Europäisches Patentamt

European Patent Office

Office européen des brevets

(19)

(11) **EP 1 188 223 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(21) Anmeldenummer: **00945596.5**

(22) Anmeldetag: **07.06.2000**

(51) Int Cl.$^7$: **H02M 1/08**, H02M 5/293

(86) Internationale Anmeldenummer:
**PCT/DE00/01845**

(87) Internationale Veröffentlichungsnummer:
**WO 00/077915 (21.12.2000 Gazette 2000/51)**

(54) **SCHALTUNGSANORDNUNG ZUR STROMVERSORGUNG EINES HALBLEITER-SCHALTGERÄTES**

CIRCUIT FOR SUPPLYING POWER TO A SEMICONDUCTOR SWITCHING DEVICE

CIRCUIT POUR L'ALIMENTATION EN COURANT D'UN DISPOSITIF DE COMMUTATION A SEMI-CONDUCTEURS

(84) Benannte Vertragsstaaten:
**DE FR**

(30) Priorität: **16.06.1999 DE 19927525**

(43) Veröffentlichungstag der Anmeldung:
**20.03.2002 Patentblatt 2002/12**

(73) Patentinhaber: **SIEMENS AKTIENGESELLSCHAFT**
**80333 München (DE)**

(72) Erfinder: **MAIER, Reinhard**
**D-91074 Herzogenaurach (DE)**

(56) Entgegenhaltungen:
**EP-A- 0 588 635        US-A- 5 736 795**
**US-A- 5 796 599**

**Beschreibung**

Die Erfindung bezieht sich auf eine Schaltungsanordnung zur Stromversorgung eines Halbleiter-Schaltgerätes gemäß dem Oberbegriff des Patentanspruches 1.

Bei Schaltgeräten mit Halbleitern als schaltaktive Elemente besteht die Notwendigkeit einer Hilfsenergie auf dem Potential der Halbleiterschalter. Dieses Potential beträgt gegen Erde bzw. Masse bzw. Neutralleiter maximal $(+/-)*\sqrt{2}$-230V. Je nach Phasenlage treten entsprechende Zwischenwerte auf.

Zur Hilfsenergieversorgung eines Halbleiter-Schaltgerätes bestehen mehrere Möglichkeiten: Es kann eine transformatorische Versorgung mit einem Anschluß zur jeweils anderen Phase hergestellt werden. Dabei müssen hohe Spannungen, beispielsweise von 400 V, sowie sich daraus ergebende Überspannungen, beherrscht werden. Daneben kann ein Anschluß an den Mittelpunktsleiter (MP) erfolgen. Hierzu sind zusätzliche verdrahtungsarbeiten notwendig, da Schaltgeräte, wie beispielsweise Leistungsschalter und Schütze, im allgemeinen keinen Anschluß der Neutral- bzw. Erdleiter haben. Möglich ist auch eine Versorgung über Übertrager, deren Wicklungen ausreichend gegeneinander isoliert sind, wozu ein Oszillator zur Übertragung auf eine Befehlseinheit notwendig ist. Hierzu sind bereits Geräte im Handel. Schließlich ist auch eine drahtlose Energieversorgung, beispielsweise auf optischen Weg über eine Anordnung aus Leucht-/Laserdioden sowie Lichtleiter und Lichtempfänger, möglich. Solche Anordnungen haben allerdings einen geringen Wirkungsgrad.

Aus der US 5 796 599 A ist eine Schaltungsanordnung zur Stromversorgung eines Halbleiterschaltgerätes mit zwei Halbleiterschaltern, welche eine Hilfsenergie benötigen, bekannt. In einem Parallelzweig zu den ersten Halbleiterschaltern sind weitere Halbleiterschalter mit zugeordnetem Kondensator vorhanden, wobei sich die weiteren Halbleiterschalter bei Umsteuerung der ersten Halbleiterschalter im entgegengesetzten Schaltzustand wie die ersten Halbleiterschalter befinden.

Davon ausgehend ist es Aufgabe der Erfindung, eine Anordnung zur Erzeugung der Hilfsenergie für Halbleiter-Schaltgeräte zu schaffen, die einen größeren Wirkungsgrad als die bekannten Anordnungen hat.

Die Aufgabe ist erfindungsgemäß durch die Gesamtheit der im Patentanspruch 1 angegebenen Merkmale gelöst. Weiterbildungen sind in den abhängigen Ansprüchen angegeben.

Bei der Erfindung mit an sich ständig aufgesteuerten Halbleiterschaltern wird also die Hilfsenergie dadurch erzeugt, daß für kurze Zeit die ersten Halbleiterschalter hochohmig gemacht werden oder durch das übergeordnete Ansteuerverfahren bereits hochohmig sind, so daß in diesem Zustand über die weiteren Halbleiterschalter die Kondensatoren geladen werden.

Die Erfindung läßt sich auf alle Halbleiter-Schaltgeräte anwenden und hat insbesondere Bedeutung für den praktischen Einsatz von Schaltgeräten mit Leistungshalbleitern auf SiC-Basis, da Siliciumkarbid inzwischen für Schalteranwendungen genutzt wird.

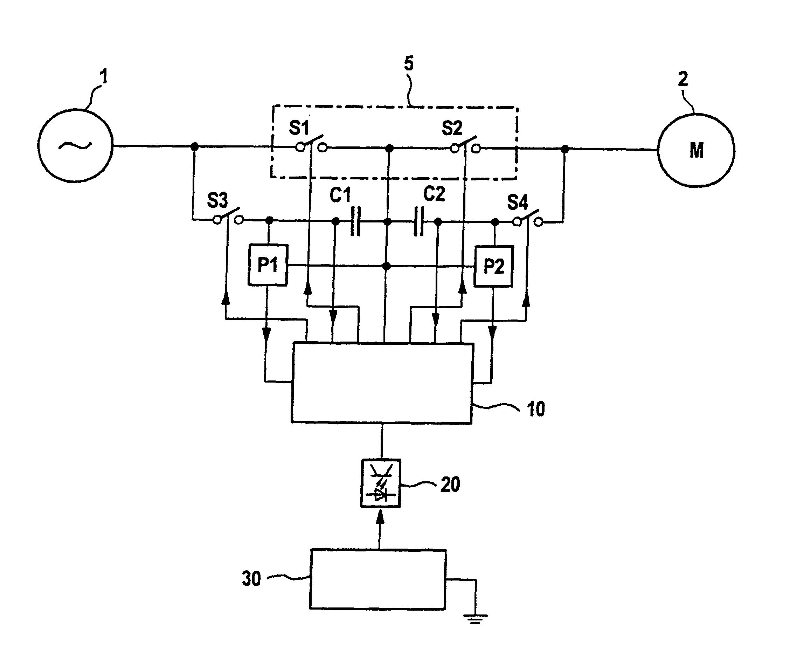

Weitere Einzelheiten und Vorteile der Erfindung ergeben sich aus den weiteren Patentansprüchen in Verbindung mit der nachfolgenden Figurenbeschreibung eines Ausführungsbeispiels anhand der Zeichnung. Die einzige Figur zeigt ein Schaltbild eines in das Netz eines Verbrauchers geschalteten Halbleiterschaltgerätes mit zugehöriger Versorgungsschaltung.

In der Figur ist mit 1 ein Wechselspannungsnetz bezeichnet, das zur Ansteuerung eines Verbrauchers, beispielsweise eines Motors 2, dient. Dem Motor 2 vorgeschaltet ist ein Halbleiter-Schaltgerät 5, das zwei Halbleiterschalter S1 und S2 beinhaltet, die als Leistungshalbleiter, insbesondere auf der Basis von Siliciumkarbid(SiC), realisiert sind.

Den beiden Halbleiterschaltern S1 und S2 des Halbleiter-Schaltgerätes 1 sind jeweils weitere Halbleiterschalter S3 bzw. S4 mit jeweils zugeordneten Kondensatoren C1 und C2 parallelgeschaltet. Dabei wird speziell der Halbleiterschalter S1 durch die Anordnung von S3 und C1 und der Halbleiterschalter S2 durch die Anordnung von S4 und C2 überbrückt. Den Kondensatoren C1 und C2 sind jeweils Einheiten P1 und P2 zugeordnet, die als Puffer-/Glättungs- und Zwischenspeichereinheiten dienen.

Letzterer Anordnung ist eine Einheit mit einer Ansteuerschaltung 10 zugeordnet, welche von einem externen Befehlsteil 30 angesteuert ist und Steuersignale für die Halbleiterschalter S1 bis S4 generiert. Dabei werden Zustandssignale von den Zwischenspeichereinheiten P1 und P2 verarbeitet. Zwischen der Ansteuerschaltung 10 und dem Befehlsteil 30 ist eine Einheit zur Potentialtrennung, beispielsweise ein Optokoppler 20, angeordnet.

Bei der anhand der Figur im einzelnen beschriebenen Schaltung wird bei den im allgemeinen ständig aufgesteuerten Halbleiterschaltern die für die Halbleiterschalter notwendige Hilfsenergie dadurch erzeugt, daß für kurze Zeit die Halbleiterschalter S1/S2 hochohmig gemacht werden oder durch das übergeordnete Ansteuerverfahren hochohmig sind, so daß dann über die weiteren Halbleiterschalter S3/S4 die weiteren Kondensatoren C1 und C2 geladen werden.

Durch die Halbleiterschalter S1 und S2 wird im allgemeinen ein hoher Strom geführt und geschaltet, beispielsweise 16/-32/64 A. Demgegenüber ist für die Ansteuerung von Halbleitern, wie z.B. MOS-Transistoren, nur eine geringe Leistung notwendig. Zusätzliche Leistung wird allerdings durch die notwendige elektronische Schaltung, z.B. zur Überwachung oder zum Abschalten im Nulldurchgang, benötigt. Dabei bleibt allerdings der Versorgungsstrom klein und liegt insgesamt im Milliamperebereich.

Damit genügt aber zur Aufladung der Speicherkondensatoren C1 und C2 eine sehr kurze Zeit, welche die Funktionsweise des an das Netz 1 angeschlossenen Verbrauchers, beispielsweise des Motors 2, in keiner Weise beeinträchtigt. Die Spannung an den Kondensatoren C1 und C2 steigt dabei zu einer maximalen Spannung von z.B. 5 - 15 V (sog. Kleinspannung) an, so daß auch der Spannungseinbruch am Verbraucher gering und damit zu vernachlässigen ist. Durch die Ansteuerschaltung 10 erfolgt die Steuerung der Schalter S1/S2/S3/S4. Gemäß Befehlssignalen aus dem Befehlsteil 30 werden über den potentialtrennenden Optokoppler 20 die Schalter S1 bis S4 in Abhängigkeit vom Ladezustand der Kondensatoren C1 und C2 angesteuert. Der Ladezustand der Kondensatoren C1 und C2 kann über Fühlerleitungen erfaßt werden. Aus den Kondensatoren C1 und C2 wird dann über die Puffer-/Glättungs- und Zwischenspeichereinheiten P1 und P2 die Hilfsenergie gewonnen.

Gemäß obigem Beispiel sind für den Betrieb des Motors die Halbleiterschalter S1 und S2 im allgemeinen aufgesteuert, d.h. leitend. Wenn die Halbleiterschalter S1 und S2 zur Begrenzung des Energieflusses zum Verbraucher dagegen nicht ständig voll aufgesteuert sind, ist es auch möglich, die Spannung am jeweils gesperrten Halbleiterschalter zur Ladung der Kondensatoren auszunutzen. Letzteres ist insbesondere vor dem ersten Einschalten des Verbrauchers sinnvoll.

Beim beschriebenen Beispiel erfolgt das Laden jeweils eines Kondensators durch kurzzeitiges Erhöhen des Durchschaltwiderstandes, d.h. Abschalten, des zugehörigen Halbleiterschalters. Damit wird bei der Schaltungsanordnung gemäß der Figur eine bipolare (+/-) Hilfsenergie erzeugt.

Mit entsprechenden Anordnungen ist es auch möglich, jeweils nur eine oder mehrere unipolare Spannungen, beispielsweise +5V, +15V oder auch -15V, separat zu erzeugen.

**Patentansprüche**

1. Schaltungsanordnung zur Stromversorgung eines HalbleiterSchaltgerätes (5) aus einem Wechselspannungsnetz (1) mit wenigstens zwei Halbleiterschaltern (S1/S2), welche eine Hilfsenergie benötigen, wobei in einem Parallelzweig zu den ersten Halbleiterschaltern (S1/S2) zwei weitere Halbleiterschalter (S3/S4) mit zugeordneten Kondensatoren (C1/C2) vorhanden und die weiteren Halbleiterschalter (S3/S2) bei Umsteuerung der ersten Halbleiterschalter (S1/S2) im entgegengesetzten Schaltzustand wie die ersten Halbleiterschalter (S1/S2) geschaltet sind, dadurch geknnzeichnet, dass eine Ansteuerschaltung zum gruppenweisen Umsteuern der ersten und weiteren Halbleiterschalter (S1/S2, S3/S4) vorhanden ist, und die Ansteuerschaltung (10) die Halbleiterschalter (S1/S2, S3/S4) gruppenweise so ansteuert, daß für eine gegenüber der Periodendauer des Wechselspannungsnetzes Zeit die ersten Halbleiterschalter (S1/S2) hochohmig sind und über die weiteren, dann niederohmigen Halbleiterschalter (S3/S4) die zugehörigen Kondensatoren (C1/C2) geladen werden.

2. Schaltungsanordnung nach Anspruch 1, **dadurch gekennzeichnet, dass** die Spannung an den Kondensatoren (C1/C2) bei der Aufladung linear ansteigt und als Kleinspannung nur einen geringen Spannungseinbruch am Verbraucher (2) bewirkt.

3. Schaltungsanordnung nach einem der vorhergehenden Ansprüche, **dadurch gekennzeichnet, dass** Zwischenspeichereinheiten (P1/P2) für Puffer und/oder Glättungszwecke vorhanden sind.

4. Schaltungsanordnung nach Anspruch 3, **dadurch gekennzeichnet, dass** eine Einheit (30) zur Erzeugung von Befehlssignalen vorhanden ist, die potentialfrei mit der Ansteuerschaltung (10) verbunden ist.

5. Schaltungsanordnung nach Anspruch 4, **dadurch gekennzeichnet, dass** zur Potentialtrennung ein Optokoppler (20) verwendet wird.

6. Schaltungsanordnung nach einem der vorhergehenden Ansprüche, **dadurch gekennzeichnet, dass** der Ladezustand der Kondensatoren (C1/C2) über geeignete Fühlerleitungen erfaßt wird.

7. Schaltungsanordnung nach einem der vorhergehenden Ansprüche, **dadurch gekennzeichnet, dass** das Halbleiter-Schaltgerät (5) wenigstens einen Leistungshalbleiter enthält.

8. Schaltungsanordnung nach Anspruch 7, **dadurch gekennzeichnet, dass** der Leistungshalbleiter Siliciumcarbid (SiC) ist.

**Revendications**

1. Circuit pour l'alimentation en courant d'un dispositif de commutation à semi-conducteurs (5) à partir d'un réseau de tension alternative (1) avec au moins deux commutateurs semi-conducteurs (S1/S2) qui ont besoin d'une énergie auxiliaire, deux autres commutateurs semi-conducteurs (S3/S4) avec condensateurs (C1/C2) associés étant montés dans une branche parallèle aux premiers commutateurs semi-conducteurs (S1/S2) et les autres commutateurs semi-conducteurs (S3/S4) étant branchés dans l'état de commutation contraire de celui des premiers commutateurs semi-conducteurs (S1/S2) lors de l'inversion des premiers commutateurs semi-conducteurs (S1/S2), **caractérisé par le fait qu'**il y a un circuit de commande pour l'inversion par groupe des premiers et des deuxièmes commutateurs semi-conducteurs (S1/S2, S3/S4) et que le circuit de commande (10) commande par groupe les commutateurs semi-conducteurs (S1/S2, S3/S4) de telle sorte que, pour une courte durée par rapport à la durée de période du réseau de tension alternative, les premiers commutateurs semi-conducteurs (S1/S2) sont à haute impédance et les condensateurs (C1/C2) associés sont chargés par l'intermédiaire des autres commutateurs semi-conducteurs (S3/S4) alors à basse impédance.

2. Circuit selon la revendication 1, **caractérisé par le fait que** la tension aux condensateurs (C1/C2) augmente de façon linéaire lors de la charge et, en tant que petite tension, provoque seulement une petite chute de tension au consommateur (2).

3. Circuit selon l'une des revendications précédentes, **caractérisé par le fait que** des unités de stockage intermédiaire (P1/P2) sont prévues pour le tampon et/ou le lissage.

4. Circuit selon la revendication 3, **caractérisé par le fait qu'**une unité (30), qui est reliée sans potentiel au circuit de commande (10), est prévue pour produire des signaux d'instruction.

5. Circuit selon la revendication 4, **caractérisé par le fait qu'**un coupleur optoélectronique (20) est utilisé pour la séparation de potentiel.

6. Circuit selon l'une des revendications précédentes, **caractérisé par le fait que** l'état de charge des condensateurs (C1/C2) est détecté par l'intermédiaire de lignes de capteurs appropriées.

7. Circuit selon l'une des revendications précédentes, **caractérisé par le fait que** le dispositif de commutation à semi-conducteurs (5) contient au moins un semi-conducteur de puissance.

8. Circuit selon la revendication 7, **caractérisé par le fait que** le semi-conducteur de puissance est en carbure de silicium (SiC).

## Claims

1. Circuit arrangement for the power supply of a semiconductor switching device (5) from an AC voltage mains system (1) with at least two semiconductor switches (S1/S2) which require auxiliary power, two further semiconductor switches (S3/S4) with allocated capacitors (C1/C2) being present in a parallel branch to the first semiconductor switches (S1/S2), and the further semiconductor switches (S3/S2) being switched in the reverse switching state like the first semiconductors (S1/S2) when the first semiconductor switches (S1/S2) are reversed, **characterised in that** a trigger circuit is provided for group reversal of the first and further semiconductor switches (S1/S2, S3/S4), and **in that** the trigger circuit (10) triggers the semiconductor switches (S1/S2, S3/S4) on a group basis such that for a brief time compared with the period of the AC voltage mains system the first semiconductor switches (S1/S2) are high-resistance and the associated capacitors (C1/C2) are charged via the further, then low-resistance semiconductor switches (S3/S4).

2. Circuit arrangement according to Claim 1, **characterised in that** the voltage at the capacitors (C1/C2) rises linearly during charging and as an extra-low voltage causes only a small voltage dip at the load (2).

3. Circuit arrangement according to one of the preceding claims, **characterised in that** buffer storage units (P1/P2) are provided for buffers and/or smoothing purposes.

4. Circuit arrangement according to Claim 3, **characterised in that** a unit (30) to generate command signals is provided, which is connected to the trigger circuit (10) on a floating basis.

5. Circuit arrangement according to Claim 4, **characterised in that** an optical coupler (20) is used for electrical isolation.

6. Circuit arrangement according to one of the preceding claims, **characterised in that** the charge state of the capacitors (C1/C2) is recorded via suitable sensor lines.

7. Circuit arrangement according to one of the preceding claims, **characterised in that** the semiconductor switching device (5) contains at least one power semiconductor

8. Circuit arrangement according to Claim 7, **characterised in that** the power semiconductor is silicon carbide (SiC).